# DEMANDE DE BREVET EUROPEEN

(11) **EP 2 416 287 A2**
(43) Date de publication de la demande: **08.02.2012**
(21) Numéro de dépôt: 11175034.5
(22) Date de dépôt: 22.07.2011
(51) Int. Cl.: G06Q 10/00, B65G 1/137, G06K 17/00, H05K 7/14, G01R 31/28

(54) **Système de localisation d'un equipement dans une salle informatique**

(30) Priorité: 05.08.2010 FR 1056452
(71) Demandeur: T & P Consulting, 75008 Paris (FR)
(72) Inventeur: Akoun, Yann, 45000 Orleans (FR); Nadaradjane, Siva, 95240 Cormeilles en Parisis (FR); M'rabet, Mohamed Sami, 42100 Saint-Etienne (FR); Kebaili, Kader, 93160 Noisy-le-grand (FR)
(74) Mandataire: Marconnet, Sébastien

(57) **Abrégé**

L'invention concerne essentiellement un système de localisation d'un équipement informatique au sein d'une salle informatique faisant appel à des premières (11) et des deuxièmes étiquettes (12.1-12.4) de type passives pouvant prendre la forme d'étiquette de type RFID. Les premières étiquettes (11) sont associées aux équipements (5) et les deuxièmes étiquettes (12.1-12.4) sont associées à une ou plusieurs zones d'une baie (3). Un système (17) d'information est capable d'afficher, à partir des informations d'identification et des informations de localisation reçues du lecteur (15), une représentation graphique des équipements en fonction de leur localisation. L'invention permet de répertorier précisément les différents équipements et de connaitre les dates d'entrée et de sortie de ces équipements afin de pouvoir calculer la valeur en temps réel du matériel présent dans la salle. L'invention facilite également la mise en place de systèmes d'aide à la décision proposant des solutions notamment pour réduire la consommation des équipements d'une salle informatique.

## Description

**DOMAINE DE L'INVENTION**

L'invention concerne un système de localisation d'un équipement dans une salle informatique. La présente invention a notamment pour but de fournir une aide à la décision afin d'exploiter au mieux les nouveaux équipements entrants dans la salle ainsi que les équipements déjà en place.

**ETAT DE LA TECHNIQUE**

Une salle informatique appelée aussi « data-center » en anglais comporte de façon connue en soi des allées dites « froides » qui sont climatisées afin d'éviter la surchauffe des équipements informatiques qui y sont installés. Ces allées froides sont séparées par des allées dites « chaudes » non climatisées. La face avant des équipements est positionnée du côté des allées froides tandis que la face arrière des équipements au niveau de laquelle sont réalisées les connexions est positionnée du côté des allées chaudes.

Plus précisément, les allées froides sont formées chacune par deux rangées de baies face à face à l'intérieur desquelles sont positionnés les équipements informatiques. En général, un toit fixé à l'armature des baies assure un rôle d'isolement thermique afin de préserver la fraîcheur de chaque allée froide.

Au sein d'une telle salle qui contient des centaines d'équipements du type serveurs, commutateurs, routeurs ou autres, la gestion des entrées et des sorties de ces équipements peut provoquer un certain nombre d'erreurs, comme la mauvaise localisation des éléments, ou des points de chaleur à cause d'une répartition trop centralisée des serveurs.

Le fait qu'il soit difficile de faire un inventaire précis des différents équipements présents dans la salle et de connaître à quelle date ces différents équipements ont été installés rend difficile une évaluation de la valeur des équipements en présence.

II existe donc le besoin de répertorier précisément les différents équipements et de connaitre les dates d'entrée et de sortie de ces équipements afin de pouvoir calculer la valeur en temps réel du matériel présent dans la salle.

Par ailleurs, la mauvaise répartition des serveurs dans la salle entraîne une consommation importante en énergie. Il existe donc un besoin d'optimisation de la gestion de l'énergie dans la salle informatique, autrement dit le besoin est de proposer des systèmes informatiques ayant un impact réduit sur l'environnement (« Green IT »).

En outre, lorsqu'une base de données répertoriant et localisant les différents éléments d'une salle serveur est utilisée, il est très difficile de la maintenir à jour car il existe un grand nombre d'entrées et de sorties d'équipements effectués par un grand nombre d'acteurs (prestataires extérieurs, opérateurs de maintenance, intégrateurs, etc...). En conséquence, il existe le besoin de pouvoir localiser à tout instant un équipement de la salle, et de pouvoir identifier le meilleur emplacement pour l'intégration d'un équipement.

L'invention se propose de répondre aux besoins précités.

**OBJET DE L'INVENTION**

A cet effet, l'invention fait appel à des étiquettes à lecture radio couplées à un système d'information. Ces étiquettes de type passif prenant par exemple la forme de puces de type RFID sont associées à l'équipement et à une zone de la salle informatique. Un système d'information est capable d'afficher, à partir des informations d'identification et des informations de localisation reçues du lecteur, une représentation graphique des équipements en fonction de leur localisation.

En outre, on sait que le service fourni par les hébergeurs est fonction du nombre de serveurs utilisés et de la puissance consommée par ces serveurs. En couplant, le cas échant, l'invention avec un système d'information extérieur fournissant des données de consommation de chaque équipement, l'invention va permettre d'estimer au plus juste le service fourni par l'hébergeur, et ce même dans le cas où l'utilisateur met en oeuvre des serveurs virtuels formés de plusieurs serveurs physiques.

On note que l'invention pourra également être utilisée pour établir une traçabilité du matériel de manière individuelle ou collective (avec un ensemble d'équipements dans un carton ou dans une palette, etc...) depuis la livraison des équipements, leur stockage, jusqu'à leur installation dans la salle serveur. Il suffira pour cela d'identifier les serveurs (pour une traçabilité individuelle) ou les cartons et les colis (pour une traçabilité collective) au moment de leur livraison et d'effectuer des lectures régulières des étiquettes dans les différentes zones.

L'invention concerne donc un système de localisation d'équipements informatiques au sein d'une salle informatique comportant des allées froides délimitées chacune par deux rangées de baies, les équipements informatiques étant installés dans les baies, ce système comportant :
- des premières et des deuxièmes étiquettes de type passives,
- les premières étiquettes étant associées aux équipements, ces premières étiquettes contenant des informations d'identification relatives à ces équipements,
- les deuxièmes étiquettes étant associées à une ou plusieurs zones d'une baie, ces deuxièmes étiquettes contenant des informations de localisation relatives à ces zones,
- au moins une antenne pour activer les étiquettes et lire les informations d'identification et de localisation contenues dans les premières et les deuxièmes étiquettes,
- un lecteur pour activer l'antenne apte à transmettre les informations des premières et des deuxièmes étiquettes vers un système de gestion,
- ce système de gestion comportant des moyens pour afficher, à partir des informations d'identification et des informations de localisation reçues du lecteur, une représentation graphique ayant une granularité allant de la salle informatique jusqu'à une baie et montrer une image des équipements contenus dans les baies.

Selon une réalisation, le système comporte des moyens pour entrer dans le système de gestion au moins paramètre parmi : l'espace disponible dans chaque baie, la puissance maximum autorisée pour chaque baie, le nombre de connexions réseau disponibles pour chaque baie, le nombre de prises électriques disponibles pour chaque baie, du poids des équipements supportable par chaque baie, et
- des moyens pour fournir, à partir des informations d'identification et de localisation captées par l'antenne, au moins un indicateur d'état correspondant parmi : l'encombrement des équipements installés dans une baie par rapport à l'espace disponible, le nombre de connexions réseau utilisées par rapport au nombre de connexions disponibles, le nombre de prises électriques utilisées par rapport au nombre de prises électriques disponibles, le poids total des équipements installés.

Selon une réalisation, le système comporte :
- des moyens pour acquérir, pour un nouvel équipement à installer les paramètres de configuration suivants : l'encombrement de l'équipement, le nombre de connexions réseau ainsi que le nombre de prises électriques nécessaires au fonctionnement de l'équipement, et la consommation énergétique de l'équipement,
- des moyens pour proposer à l'utilisateur le meilleur emplacement dans la salle informatique pour ce nouvel équipement, en fonction de ces paramètres de configuration et des indicateurs d'état.

Selon une réalisation, le système comporte en outre :
- un rail installé dans la salle informatique,
- l'antenne portée par le rail pouvant se déplacer de façon autonome sur ce rail pour parcourir tout ou partie de la salle informatique.

Selon une réalisation, le rail présente une forme rectiligne ou une forme de boucle fermée.

Selon une réalisation, l'antenne est reliée au rail par l'intermédiaire d'un bras articulé en rotation autour d'un axe vertical pour balayer les deux côtés d'une allée et/ou déplaçable en translation suivant l'axe vertical.

Selon une réalisation, la salle informatique comportant un toit solidaire de la structure des baies, l'antenne est
- fixée au toit ou
- simplement posée sur la face du toit dirigée vers l'extérieur de la salle lorsque le toit est réalisé dans un matériau de type plexiglas ou tout autre matériau transparent.

Selon une réalisation, l'antenne couvre une zone correspondant à une baie unique.

Selon une réalisation, une ou plusieurs antennes sont installées sur un portique positionné à l'entrée de la salle informatique permettant de détecter l'entrée et la sortie des équipements à l'intérieur de la salle informatique.

Selon une réalisation, le système comporte en outre au moins une troisième étiquette de type active ou passive dite étiquette environnementale associée à chaque baie, cette étiquette étant munie au moins d'un capteur de température et/ou d'humidité.

Selon une réalisation, chaque baie comporte un nombre de deuxièmes étiquettes adapté à la précision du maillage géographique souhaité, ce nombre étant de préférence égal à trois pour chaque baie afin de pouvoir distinguer la zone haute, basse et intermédiaire de la baie.

Selon une réalisation, l'antenne est positionnée sur un chariot mobile et élévateur.

Selon une réalisation, le système comporte un dispositif de signalisation visuel et/ou sonore indiquant que l'antenne est en cours de fonctionnement.

Selon une réalisation, le système comporte en outre une table d'encodage pour encoder les premières et les deuxièmes étiquettes comprenant :
- un encodeur d'étiquettes apte à affecter un identifiant unique à une étiquette donnée,
- une interface homme-machine permettant à l'opérateur de sélectionner l'identifiant contenu dans une liste ou de créer l'identifiant à partir d'un algorithme de calcul, et
- une zone d'isolement permettant d'isoler l'étiquette des perturbations extérieures pour garantir l'écriture sur l'étiquette isolée.

Selon une réalisation, le système comporte un dispositif d'impression apte à inscrire de manière visible sur l'étiquette une information complémentaire identique ou non à l'identifiant inscrit dans l'étiquette.

**BREVE DESCRIPTION DES DESSINS**

L'invention sera mieux comprise à la lecture de la description qui suit et à l'examen des figures qui l'accompagnent. Ces figures ne sont données qu'à titre illustratif mais nullement limitatif de l'invention. Elles montrent :

Figure 1 : une vue extérieure, en 3 dimensions, d'une allée froide à l'intérieur de laquelle est installé un système de localisation selon l'invention ;

Figure 2 : une vue intérieure, en 3 dimensions, de l'allée froide de la figure 1 faisant apparaître deux baies côte à côte muni d'étiquettes ;

Figure 3 : une vue détaillée des deux baies côte à côte de la Figure 2 ;

Figure 4 : une représentation schématique d'un lecteur et des antennes qui lui sont associées ;

Figure 5 : une représentation schématique d'un portique d'entrée et de sortie du système de localisation selon l'invention ;

Figure 6 : une vue extérieure en 3 dimensions d'une allée froide à l'intérieure de laquelle est installé un rail du système de localisation selon l'invention le long duquel une antenne est apte à se déplacer ;

Figure 7 : une vue intérieure en 3 dimensions de la l'allée froide de la Figure 6 ;

Figure 8 : une représentation schématique fonctionnelle globale du système d'identification selon l'invention montrant l'interaction entre le système d'information et les différents éléments du système ;

Figure 9 : une représentation schématique d'une table d'encodage du système selon l'invention permettant de stocker un identifiant dans la mémoire des étiquettes passives mises en oeuvre dans l'invention.

Les éléments identiques, similaires ou analogues conservent la même référence d'une figure à l'autre.

**DESCRIPTION D'EXEMPLES DE REALISATION DE L'INVENTION**

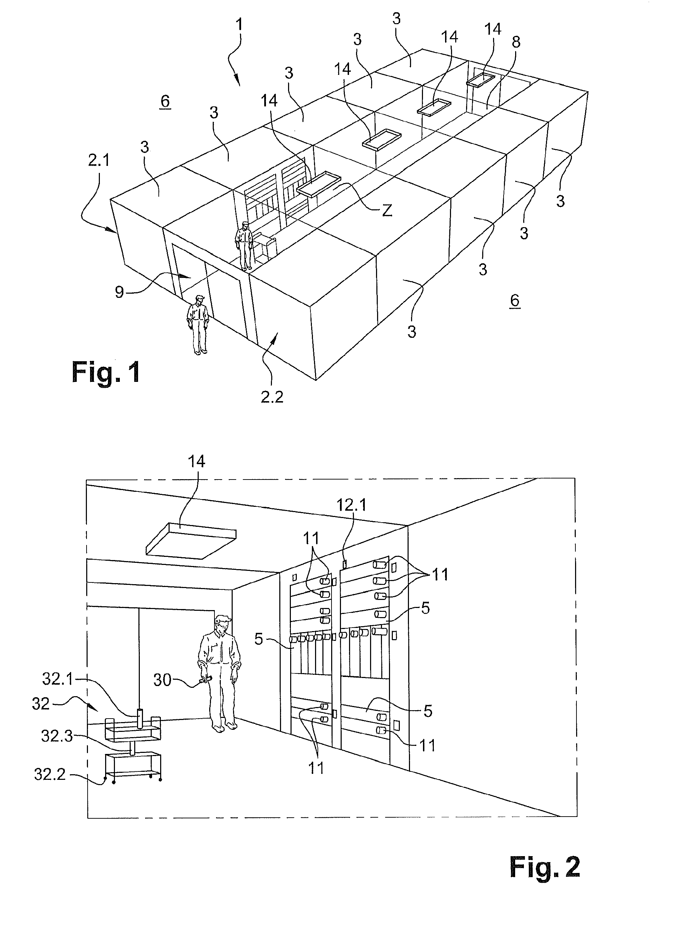

Les Figures 1 et 2 montrent une allée froide 1 d'une salle informatique délimitée par deux rangées 2.1, 2.2 de baies 3. Des équipements 5 informatiques sont installés horizontalement ou verticalement à l'intérieur des baies 3. Les faces avant des équipements sont positionnées du côté de l'allée froide 1 ; tandis que les faces arrière au niveau desquelles sont réalisées les connexions sont positionnées du côté d'allées chaudes 6 qui séparent les allées froides 1 entre elles.

L'allée froide 1 comporte également un toit 8 généralement en plexiglas fixé aux armatures des baies 3 assurant l'isolation thermique de l'allée froide 1. Ce toit 8 est distinct du plafond ou du faux-plafond (non représenté) de la salle informatique en tant que tel. Des portes 9 coulissantes permettent également d'assurer une isolation thermique ainsi qu'un contrôle d'accès à la salle informatique.

Comme montré sur la Figure 2, les équipements 5 de la salle sont munis d'étiquettes 11. Chaque étiquette 11 contenant dans sa mémoire des informations d'identification de l'équipement 5 auquel elle correspond. Les étiquettes 11 sont de préférence de type passives. On rappelle qu'une étiquette passive est une étiquette dépourvue de batterie activable par un signal de sollicitation émis par une antenne fixe ou mobile.

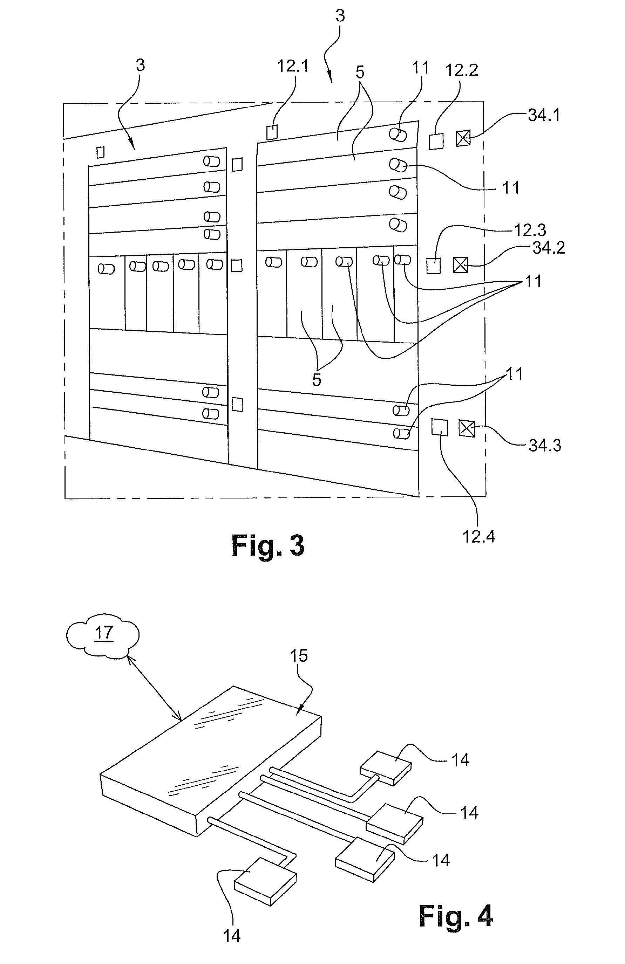

Par ailleurs, comme montré sur la Figure 2 et plus en détails sur la Figure 3, des étiquettes 12.1-12.4 également de type passives sont associées à une ou plusieurs zones de chaque baie 3. Ces étiquettes 12.1-12.4 contiennent des informations dites « de localisation » correspondant à ces zones. Dans un exemple, on utilise une première étiquette 12.1 pour identifier la baie 3, et trois autres étiquettes 12.2-12.4 pour identifier les zones haute et basse de la baie ainsi que la zone intermédiaire située entre ces zones. En variante, on utilise plus ou moins d'étiquettes 12.1-12.4 en fonction de la précision du maillage géographique recherché.

Des antennes sont utilisées pour lire les informations d'identification ou de localisation stockées dans les étiquettes 11 et 12.1-12.4. Sur les Figures 1 et 2, les antennes 14 sont fixées sur le toit 8 de la salle informatique. Dans une réalisation, les antennes 14 sont fixées à l'aide de moyen d'attache sur la face intérieure du toit 8 orientée vers l'intérieur de la salle informatique. En variante, les antennes 14 sont simplement posées sur la face du toit 8 orientée vers l'extérieur de la salle, ce qui permet d'économiser du temps de montage. En outre, on note que comme le toit 8 est réalisé dans un matériau de type plexiglas ou tout autre type de matériau ayant des propriétés équivalentes, il n'y a pas de problème de transmission du signal des antennes 14 à l'intérieur de la salle informatique.

Chaque antenne 14 positionnée entre les rangées de baies 3 couvre une zone Z correspondant à quatre baies à savoir deux baies 3 face à face (cf Figure 1), ce qui permet d'avoir une bonne efficacité dans la lecture des différentes étiquettes 11, 12.1-12.4. En variante, l'antenne 14 couvre deux baies 3 à savoir une baie face à une autre baie. Dans une réalisation dégradée non symétrique, il serait également possible d'envisager l'utilisation une antenne 14 couvrant une zone correspondant à trois baies.

Au moment de l'installation, il sera possible de régler la puissance des antennes afin de limiter les éventuels risques sanitaires.

Ces antennes 14 sont associées à un lecteur 15 montré sur la Figure 4. Dans un exemple de réalisation, on associe quatre antennes 14 à un lecteur 15. En variante, plus ou moins de quatre antennes peuvent être associées au lecteur 15.

Ce lecteur 15 est en relation avec un système 17 de gestion capable d'afficher à partir des informations d'identification et des informations de localisation des étiquettes 11, 12.1-12.4, une représentation graphique des équipements 5 à l'intérieur des différentes baies 3.

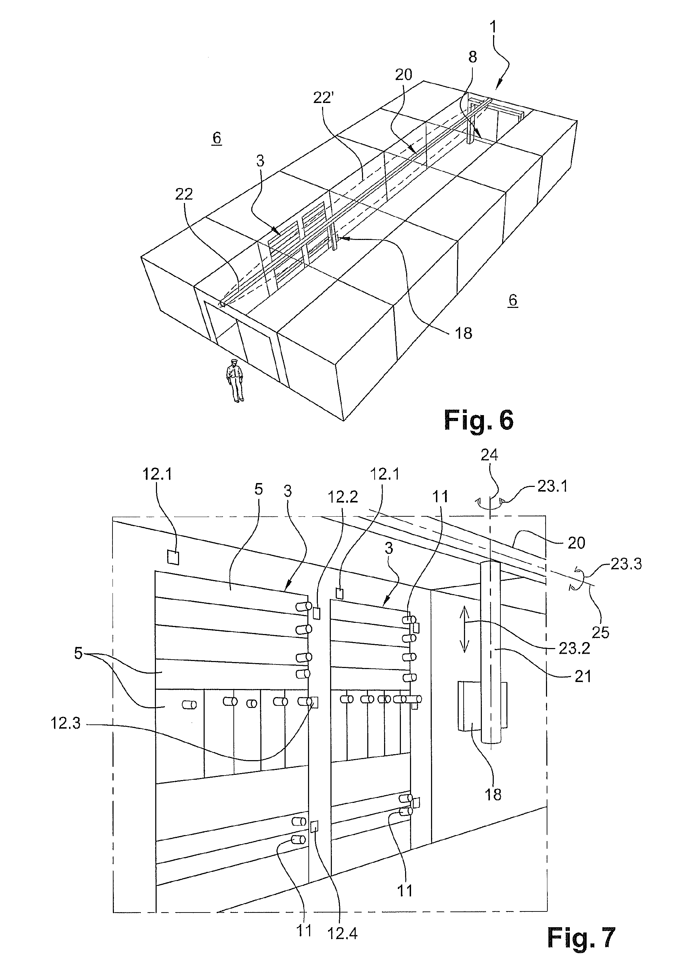

En remplacement ou en complément des antennes 14, comme montré sur les Figures 6 et 7, on utilise une antenne 18 portée par un rail 20 installé sur le toit de l'allée froide 1. L'antenne 18 peut se déplacer le long de ce rail 20 pour parcourir tout ou partie d'une allée froide 1. Un tel système permet d'augmenter le niveau d'efficacité entre les échanges de signaux entre les étiquettes 11, 12.1-12.4 et l'antenne 18 qui sont optimum lorsque l'antenne 18 est en mouvement par rapport aux étiquettes 11, 12.1-12.4. De préférence, la vitesse de l'antenne 18 sur le rail 20 est de l'ordre de 4 à 10 km/h. Le rail 20 peut présenter une forme rectiligne 22 ou une forme d'une boucle fermée 22' représentée en pointillés faisant de préférence le tour de la salle informatique. Dans une réalisation préférentielle évitant les interférences d'acquisition d'une baie à l'autre, l'antenne 18 couvre une zone correspondant à une seule baie.

Comme montré sur la Figure 7, l'antenne 18 est reliée au rail 20 par l'intermédiaire d'un bras 21 articulé pouvant pivoter 23.1 suivant un axe vertical 24 (qui se situe dans un plan sensiblement perpendiculaire au sol de la salle) pour passer d'une première position dans laquelle l'antenne 18 est tournée en direction d'une rangée de baies 3 à une deuxième position dans laquelle l'antenne 18 est tournée en direction de la rangée de baies opposée. Le mouvement de rotation du bras 21 autour de l'axe 24 permet ainsi de balayer facilement les deux côtés d'une allée froide 1. Ce mode de réalisation est particulièrement avantageux dans le cas où le rail 20 présente une forme rectiligne et qu'une antenne 18 diffusant d'un seul côté est utilisée.

En outre, le bras 21 peut déplacer l'antenne 18 (qui ne couvre qu'un seul côté d'une allée) en translation 23.2 suivant l'axe vertical 24, afin de permettre une détection optimale des étiquettes 11, 12.1-12.4 sur toute la hauteur des baies 3 de la salle informatique. En variante, on utilise une antenne 18 diffusant simultanément vers les deux côtés de l'allée froide 1.

Selon une réalisation particulière, le bras 21 est apte à pivoter 23.3 autour d'un axe 25 sensiblement horizontal (qui se situe sensiblement dans un plan parallèle au sol de la salle informatique). Ainsi, le bras 21 peut passer d'une position dépliée verticale dans laquelle il déplace l'antenne 18 le long du rail 20 à une position repliée horizontale de rangement. Dans un exemple, la zone de rangement de l'antenne est située sensiblement au milieu d'une allée froide 1.

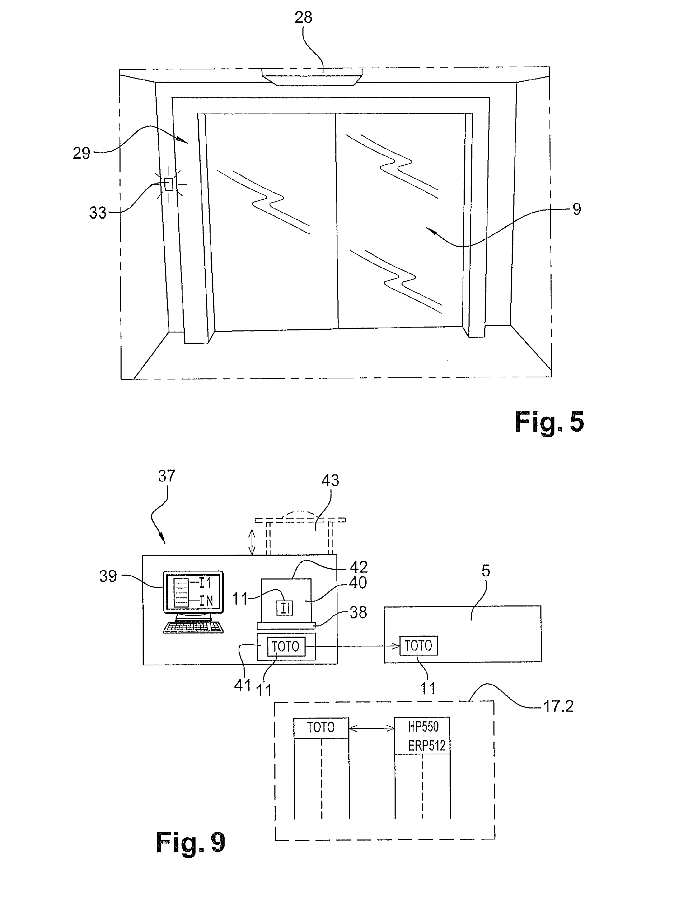

Comme montré sur la Figure 5, le système selon l'invention peut comporter également une antenne 28 installée sur un portique 29 positionné à l'entrée de la salle informatique permettant de détecter l'entrée et la sortie des équipements, en particulier des serveurs, à l'intérieur de la salle informatique.

Il est également possible d'utiliser en complément ou en remplacement des antennes fixes 14 ou mobile 18, un lecteur portatif 30 (cf Figure 2) muni d'une antenne, la lecture des différents étiquettes 11, 12.1-12.4 étant alors effectuée par le déplacement d'un opérateur dans la salle informatique. Il est également possible d'utiliser un chariot mobile 32 muni d'une antenne 32.1. Ce chariot 32 comporte des moyens 32.2 pour se déplacer sur le sol de la salle et des moyens 32.3 pour se déplacer suivant la direction verticale afin de lire convenablement les étiquettes situées en hauteur dans la salle.

De préférence, comme montré sur la Figure 5, on installe en entrée de l'allée froide 1 ou de la salle informatique un dispositif 33 de signalisation visuel et/ou sonore indiquant que l'antenne 14, 18 est en cours de fonctionnement. Ce dispositif 33 pourra par exemple commander un blocage des portes coulissantes 9 permettant l'accès à la salle informatique.

Comme visible sur la Figure 3, Il est également possible d'utiliser des étiquettes 34.1-34.3 dites « environnementales » munies d'un capteur de température et/ou d'un capteur d'humidité. De préférence, pour chaque baie 3, on utilise trois étiquettes 34.1-34.3 positionnées respectivement dans une partie haute, une partie basse et une partie intermédiaire des baies 3. Cela permet ainsi d'avoir une connaissance de la température et du taux d'humidité qui varie en fonction de la hauteur de la salle. Selon une réalisation, les étiquettes 34.1-34.3 peuvent être intégrées aux étiquettes 12.2-12.4. Les étiquettes 34.1-34.3 sont de préférence actives, c'est-à-dire qu'elles comportent leur propre source d'énergie et émettent régulièrement des signaux correspondant à leurs mesures à destination des antennes 14, 18. En variante, les étiquettes 34.1-34.3 sont des étiquettes passives.

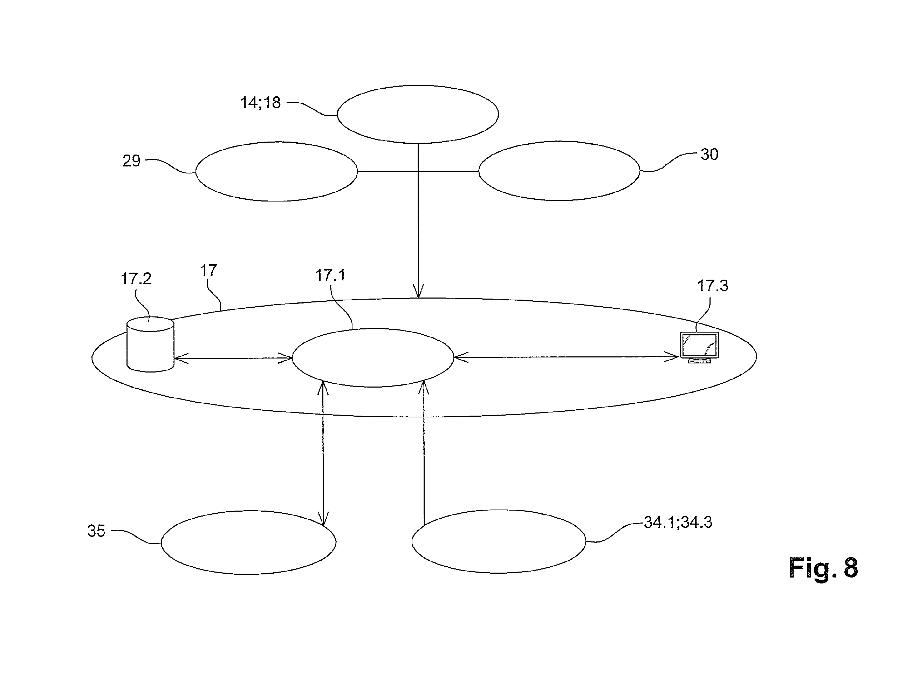

La Figure 8 montre l'interaction entre le système de gestion 17 et les lecteurs 15 associés à des antennes automatiques 14, 18 et/ou manuelles 30, et éventuellement également avec le portique 29, les étiquettes environnementales 34.1-34.3, et un logiciel 35 externe de gestion. Le système 17 est formé par un logiciel d'analyse 17.1 en relation avec une base de données 17.2 et une interface homme/machine 17.3 permettant à l'utilisateur de soumettre ses requêtes et de consulter les réponses fournies par le système 17.

En fonctionnement, les antennes 14, 18 émettent des signaux de sollicitation à destination des étiquettes 11, 12.1-12.4 qui répondent en envoyant les informations d'identification et les informations de localisation captées par les antennes 14, 18. Les lecteurs 15 associés transmettent alors les informations captées au système 17 qui fournit alors, via l'interface 17.3, une indication de préférence sous forme graphique du positionnement des différents équipements 5 dans la salle informatique. La représentation graphique a une granularité allant de la salle informatique jusqu'à une baie. Cette représentation graphique fait apparaître les équipements 5 que la salle ou que cette baie contient. Le cas échéant, la représentation graphique de la salle informatique pourra être effectuée en trois dimensions.

L'utilisateur entre via l'interface homme/machine 17.3 au moins paramètre parmi : l'espace disponible dans chaque baie 3, la puissance maximum autorisée pour chaque baie 3, le nombre de connexions réseau disponibles pour chaque baie 3, le nombre de prises électriques disponibles pour chaque baie 3, du poids des équipements supportable par chaque baie 3. De préférence, l'utilisateur entre l'ensemble de ces paramètres dans le système de gestion.

A partir des informations d'identification et de localisation captées par l'antenne 14, 18, le système de gestion 17 fournit au moins un indicateur d'état correspondant parmi : l'encombrement des équipements 5 installés dans une baie 3 par rapport à l'espace disponible, le nombre de connexions réseau utilisées par rapport au nombre de connexions disponibles, le nombre de prises électriques utilisées par rapport au nombre de prises électriques disponibles, le poids total des équipements installés. A cet effet, les informations d'identification contenues dans les étiquettes comportent des paramètres de configuration, à savoir : l'encombrement de l'équipement 5, le nombre de connexions réseau ainsi que le nombre de prises électriques nécessaires au fonctionnement de l'équipement 5, et la consommation énergétique de l'équipement 5. Alternativement, l'utilisateur pourra entrer ces informations de configuration manuellement dans le système de gestion.

Lorsqu'un nouvel équipement 5 est à installer, le système de gestion 17 acquiert les paramètres de configuration du nouvel équipement 5 et propose à l'utilisateur le meilleur emplacement dans la salle informatique pour ce nouvel équipement, en fonction des paramètres de configuration du nouvel équipement et des indicateurs d'état. Ainsi par exemple, le système de gestion 17 propose d'installer un équipement consommant beaucoup dans une baie à proximité de la source de froid ; tandis qu'il propose d'installer un équipement consommant peu d'énergie dans une baie éloignée de cette source.

Dans le cas où il existe un retour d'information sur la température et ou l'humidité, le système 17 sera capable d'afficher une cartographie du niveau de température (et le cas échéant d'humidité) dans la salle informatique. Des informations transmises par le logiciel externe de gestion, comme le niveau de consommation, permettront de donner une bonne visibilité sur la consommation au niveau de granularité souhaité (équipement seul, groupe d'équipements formant un serveur virtuel, baie, allée froide, ou salle entière) et si besoin de proposer des solutions pour réduire la consommation des équipements 5.

La Figure 9 montre une représentation schématique d'une table 37 d'encodage du système selon l'invention permettant de stocker un identifiant dans la mémoire des étiquettes passives 11. A cet effet, la table 37 comprend un encodeur 38, une interface 39 homme-machine tactile ou autre permettant à l'opérateur de sélectionner l'identifiant li parmi une liste d'identifiants l1-ln ou de créer l'identifiant à partir d'un algorithme de calcul, et une zone 40 d'isolement permettant d'isoler l'étiquette 11 des perturbations extérieures pour garantir l'écriture sur l'étiquette 11. Selon une réalisation, cette zone 40 est réalisée à partir d'une cloche 42 ou d'un tiroir 43 représenté en pointillés.

Ainsi, il suffira à l'utilisateur de positionner une étiquette 11 à l'intérieur de la zone 40 d'isolement, de sélectionner un identifiant li via l'interface 39, et d'activer l'encodeur 38 afin d'affecter un identifiant unique li à une étiquette 11 donnée. De préférence, un dispositif d'impression 41 apte à inscrire de manière visible sur l'étiquette 11 une information complémentaire identique ou non à l'identifiant. Dans l'exemple de la Figure 9, la chaîne de caractères « toto » est inscrite l'étiquette 11 sera ensuite collée sur l'équipement 5 correspondant.

L'utilisateur pourra ensuite établir dans la base de données 17.2 une corrélation entre l'identifiant li affecté à l'étiquette et des paramètres P de l'équipement 5 correspondant. Les paramètres P de l'équipement pourront consister en une indication du modèle de l'équipement et, dans le cas d'un serveur, du logiciel qu'il exécute.

## Revendications

1. Système de localisation d'équipements (5) informatiques au sein d'une salle informatique comportant des allées froides (1) délimitées chacune par deux rangées de baies (3), les équipements (5) informatiques étant installés dans les baies, ce système comportant :
- des premières (11) et des deuxièmes étiquettes (12.1-12.4) de type passives,
- les premières étiquettes (11) étant associées aux équipements (5), ces premières étiquettes contenant des informations d'identification relatives à ces équipements (5),
- les deuxièmes étiquettes (12.1-12.4) étant associées à une ou plusieurs zones d'une baie (3), ces deuxièmes étiquettes contenant des informations de localisation relatives à ces zones,
- au moins une antenne (14, 18) pour activer les étiquettes (11, 12.1-12.4) et lire les informations d'identification et de localisation contenues dans les premières (11) et les deuxièmes (12.1-12.4) étiquettes,
- un lecteur (15) pour activer l'antenne (14, 18) apte à transmettre les informations des premières (11) et des deuxièmes (12.1-12.4) étiquettes vers un système de gestion (17),
- ce système de gestion (17) comportant des moyens pour afficher, à partir des informations d'identification et des informations de localisation reçues du lecteur (15), une représentation graphique ayant une granularité allant de la salle informatique jusqu'à une baie et montrer une image des équipements (5) contenus dans les baies.

2. Système selon la revendication 1, **caractérisé en ce qu'**il comporte :
- des moyens pour entrer dans le système de gestion au moins paramètre parmi : l'espace disponible dans chaque baie (3), la puissance maximum autorisée pour chaque baie (3), le nombre de connexions réseau disponibles pour chaque baie (3), le nombre de prises électriques disponibles pour chaque baie (3), du poids des équipements supportable par chaque baie (3), et
- des moyens pour fournir, à partir des informations d'identification et de localisation captées par l'antenne (14, 18), au moins un indicateur d'état correspondant parmi : l'encombrement des équipements (5) installés dans une baie (3) par rapport à l'espace disponible, le nombre de connexions réseau utilisées par rapport au nombre de connexions disponibles, le nombre de prises électriques utilisées par rapport au nombre de prises électriques disponibles, le poids total des équipements installés.

3. Système selon la revendication 2, **caractérisé en ce qu'**il comporte :
- des moyens pour acquérir, pour un nouvel équipement (5) à installer, les paramètres de configuration suivants : l'encombrement de l'équipement (5), le nombre de connexions réseau ainsi que le nombre de prises électriques nécessaires au fonctionnement de l'équipement (5), et la consommation énergétique de l'équipement (5),
- des moyens pour proposer à l'utilisateur le meilleur emplacement dans la salle informatique pour ce nouvel équipement, en fonction de ces paramètres de configuration et des indicateurs d'état.

4. Système selon l'une des revendications 1 à 3, **caractérisé en ce qu'**il comporte en outre :
- un rail (20) installé dans la salle informatique,
- l'antenne (14) portée par le rail (20) pouvant se déplacer de façon autonome sur ce rail (20) pour parcourir tout ou partie de la salle informatique.

5. Système selon la revendication 4, **caractérisé en ce que** le rail (20) présente une forme rectiligne (22) ou une forme de boucle fermée (22').

6. Système selon la revendication 4 ou 5, **caractérisé en ce que** l'antenne (14) est reliée au rail (20) par l'intermédiaire d'un bras (21) articulé en rotation autour d'un axe (24) vertical pour balayer les deux côtés d'une allée et/ou déplaçable en translation suivant l'axe vertical (24).

7. Système selon l'une des revendications 1 à 6, **caractérisé en ce que** la salle informatique comportant un toit (8) solidaire de la structure des baies (3), l'antenne (18) est
- fixée au toit (8) ou
- simplement posée sur la face du toit (8) dirigée vers l'extérieur de la salle lorsque le toit (8) est réalisé dans un matériau de type plexiglas ou tout autre matériau transparent.

8. Système selon la revendication 7, **caractérisé en ce que** l'antenne (18) couvre une zone correspondant à une baie (3) unique.

9. Système selon l'une des revendications 1 à 8, **caractérisé en ce que** une ou plusieurs antennes sont installées sur un portique (29) positionné à l'entrée de la salle informatique permettant de détecter l'entrée et la sortie des équipements (5) à l'intérieur de la salle informatique.

10. Système selon l'une des revendications 1 à 9, **caractérisé en ce que** qu'il comporte en outre au moins une troisième étiquette (34.1-34.3) de type active ou passive dite étiquette environnementale associée à chaque baie (3), cette étiquette (34.1-34.3) étant munie au moins d'un capteur de température et/ou d'humidité.

11. Système selon l'une des revendications 1 à 10, **caractérisé par** chaque baie (3) comporte un nombre de deuxièmes étiquettes (12.1-12.4) adapté à la précision du maillage géographique souhaité, ce nombre étant de préférence égal à trois pour chaque baie (3) afin de pouvoir distinguer la zone haute, basse et intermédiaire de la baie (3).

12. Système selon l'une des revendications 1 à 11, **caractérisé en ce que** l'antenne est positionnée sur un chariot (32) mobile et élévateur.

13. Système selon l'une des revendications 1 à 12, **caractérisé en ce qu'**il comporte un dispositif (33) de signalisation visuel et/ou sonore indiquant que l'antenne (14, 18) est en cours de fonctionnement.

14. Système selon l'une des revendications 1 à 13, **caractérisé en ce qu'**il comporte en outre une table (37) d'encodage pour encoder les premières (11) et les deuxièmes (12.1-12.4) étiquettes comprenant :
- un encodeur (38) d'étiquettes apte à affecter un identifiant unique à une étiquette donnée,
- une interface (39) homme-machine permettant à l'opérateur de sélectionner l'identifiant contenu dans une liste ou de créer l'identifiant à partir d'un algorithme de calcul, et
- une zone (40) d'isolement permettant d'isoler l'étiquette des perturbations extérieures pour garantir l'écriture sur l'étiquette isolée.

15. Système selon la revendication 14, **caractérisé en ce qu'**il comporte un dispositif (41) d'impression apte à inscrire de manière visible sur l'étiquette (11, 12.1-12.4) une information complémentaire identique ou non à l'identifiant inscrit dans l'étiquette.
